# FASCICULE DE BREVET EUROPEEN

(11) **EP 1 143 379 B1**
(45) Date de publication et mention de la délivrance du brevet: **06.02.2008**
(21) Numéro de dépôt: 01400857.7
(22) Date de dépôt: 03.04.2001
(51) Int. Cl.: G06K 19/077

(54) **Procédé de réalisation d'une carte à puce mixte**
Verfahren zur Realisierung einer gemischten Chip-Karte
Method of realising a mixed chip card

(30) Priorité: 03.04.2000 FR 0004238
(43) Date de publication de la demande: 10.10.2001
(73) Titulaire: SAGEM Sécurité, 75015 Paris (FR)
(72) Inventeur: Darnault, Patrick, 95000 Cergy (FR)
(74) Mandataire: Schmit, Christian Norbert Marie

(56) Documents cités:
- FR-A- 2 753 819
- FR-A- 2 780 848
- US-A- 5 898 215

## Description

L'invention a pour objet un procédé de réalisation d'une carte à puce mixte et une carte à puce mixte incluant un circuit électrique dans une couche enterrée de la carte. Le but de l'invention est d'optimiser la réalisation d'une connexion entre une puce et un circuit électrique présent dans une couche enterrée de la carte. Le domaine de l'invention concerne les cartes à puce mixtes, c'est-à-dire des cartes qui comportent un circuit électrique principal, avec la puce accessible par un connecteur de type à contact, mais aussi un circuit électrique secondaire présent dans une couche enterrée de la carte. Le circuit secondaire peut être une antenne et servir pour une communication de type sans contact avec la carte.

Une carte à puce comporte en général un micromodule encastré dans un logement réalisé selon l'épaisseur de la carte. Le micromodule est constitué d'une puce et d'une vignette. La puce est un circuit intégré électronique de la carte à puce. Pour permettre une liaison de la puce avec un lecteur de carte à puce de type à contact, la vignette joue un rôle d'interface électrique.

La vignette est généralement constituée par un film isolant sur lequel ont été réalisées, sur une face de dessus de la vignette, des zones conductrices par métallisation. Les zones conductrices sont réparties indépendamment les unes des autres. Leur répartition respecte une norme. Le film isolant comporte des trous. Les trous sont repartis conformément à une répartition de plots de contact au sommet de la puce. Les trous permettent de réaliser des connexions entre les plots présents sur le sommet de la puce et les faces du dessous des zones conductrices de la vignette en regard de ces trous. La puce est fixée par sa base sur une face du dessous de la vignette. La puce est reliée à des zones conductrices de cette face de dessous par des liaisons électriques généralement réalisées par une technique dite de wire bonding (liaison par fil) dans laquelle une machine débite un fil conducteur très fin face à une pane de soudage. La machine soude ainsi des extrémités de segments de ce fil alternativement sur des plots de contact réalisés au sommet de la puce et dans les trous sur le dos des métallisations. L'espace vide restant sous la face du dessous de la vignette et entre les fils est rempli par une substance isolante.

Les zones conductrices de la vignette peuvent réaliser par exemple une fonction d'alimentation, une connexion à une masse ou une fonction d'entrée-sortie de données. La substance isolante utilisée est en général du plastique.

Le micromodule peut comporter un renflement dans une zone où est placée la puce. Ce renflement est entouré par des ailes fines débordant de cette zone de renflement. Les bords latéraux de la zone de renflement peuvent comporter des murs réalisés avec de la matière du film isolant, ou en même temps que le film isolant. Le bord longitudinal du renflement protège la puce et ses connexions avec les zones conductrices.

Le logement du micromodule dans une carte à puce peut être usiné par fraisage ou estampage avant ou après laminage des couches de la carte à puce. Les cartes à puce peuvent aussi être réalisées à partir de plusieurs couches assemblées pouvant préalablement comporter une cavité ou un percement correspondant à ce logement.

Une carte à puce sans contact ne comporte pas de vignette avec des zones conductrices. Un logement pour une puce sans contact peut dans une version simple être réalisé dans une première couche de carte. Ce logement présente une cavité où est fixée la puce. Cette cavité débouche sur une face supérieure de cette première couche. Un circuit secondaire, notamment une antenne, est placé sur cette face supérieure de cette première couche de carte, de telle façon que des plots de connexion à ce circuit secondaire soient accessibles à une machine de wire bonding disposée face à cette face supérieure, en même temps que des plots du sommet de la puce. Par la suite la cavité est remplie de matière isolante, et ou une couche supérieure de carte est plaquée contre la première à titre de protection. Le circuit secondaire peut servir d'interface radioélectrique.

Une carte mixte est en théorie une carte à puce avec contact (munie donc d'une vignette) et une carte à puce qui comporte un circuit électrique secondaire présent dans une couche enterrée de la carte (par exemple pour un usage sans contact). Le circuit secondaire s'ajoute au circuit principal défini par le micromodule. Le problème présenté par une telle carte mixte est qu'une machine de wire bonding ne peut pas à la fois réaliser la liaison des plots de la puce aux métallisations du micromodule (par en dessous) et la liaison des plots de la puce aux plots de l'antenne (par le dessus). Des procédés de réalisation industrielle de cartes à puce mixtes n'existent donc pas. FR-A- 2 780 848 divulgue une carte à puce ayant les caractéristiques dans le préambule de la revendication 3.

Dans l'invention, pour aboutir à cette fabrication industrielle, on a choisi de réaliser des puits de connexion conduisant, dans une couche de carte supérieure, d'une face inférieure du circuit électrique principal constitué par le micromodule à une face supérieure d'une autre couche de carte, sur laquelle est placé le circuit électrique secondaire. Pour assurer la connexion électrique, on a alors choisi de faire couler de la colle conductrice dans ces puits. Lorsque le micromodule est mis en place, des colonnes de colle conductrice assurent alors la connexion électrique entre des plots du circuit secondaire et des métallisations du dessous du micromodule. Les métallisations concernées sont alors telles qu'elles conduisent dans le micromodule, par une reprise par liaison électrique, à des plots présents au sommet de la puce.

Dans l'invention deux procédés de réalisation d'une carte à puce mixte sont proposés. Un premier procédé consiste à réaliser dans un premier temps une première couche isolante et constituante du corps de la carte. Puis on applique, sur cette première couche, une première face d'un circuit secondaire. Une deuxième couche isolante constituante est ensuite plaquée sur une deuxième face du circuit secondaire. Des puits sont alors réalisés à l'aide d'une fraise qui va creuser la deuxième couche. Les puits creusés sont remplis d'une colle conductrice. Puis le circuit principal présenté dans un micromodule comportant des métallisations, réalisant une interface avec une puce, est mis en place dans une cavité de la deuxième couche constituante. Une métallisation de dessous du circuit principal et un plot de connexion du circuit secondaire sont alors reliés électriquement grâce à la colle conductrice.

A cet effet l'invention concerne donc un procédé de réalisation d'une carte à puce comportant les étapes suivantes :
- on forme une première couche isolante de constitution d'un corps de la carte,
- on plaque contre cette première couche constituante une première face d'un circuit électrique secondaire
- on réalise par ailleurs une deuxième couche constituante plaquée contre une deuxième face du circuit électrique secondaire
- on introduit, dans une cavité de cette deuxième couche constituante, un micromodule ayant une puce une zone de renflement où est fixée la puce et des ailes de part et d'autre du renflement,
- on fraise des puits dans les ailes du micromodule et dans la deuxième couche constituante jusqu'à la deuxième face du circuit secondaire,
- on remplit les puits d'une colle conductrice,
- on met en place un circuit électrique principal comportant des métallisations pour être connecté à un lecteur de cartes à puce à contact, la colle conductrice dans les puits étant alors en contact direct avec deux points de connexion du circuit électrique secondaire et avec deux points de connexion du circuit électrique principal par le dessous des métallisations de ce circuit électrique principal .

Mais ce procédé n'est pas entièrement satisfaisant. En effet pour mettre à jour un plot du circuit électrique secondaire présent dans une couche enterrée de la carte afin de le relier électriquement à un plot d'une puce de carte à puce, un fraisage n'est pas suffisamment précis. L'altitude de la surface de la couche support de la carte n'est pas définie de façon suffisamment précise pour contrôler un enfoncement d'une fraise ordinairement utilisée. L'épaisseur d'une carte est en effet égale à environ 760 µm. Une couche a une épaisseur de l'ordre de 300µm à 400 µm et un circuit électrique a une épaisseur de l'ordre de 50µm, notamment dans le cas où le circuit électrique présent dans une couche enterrée de la carte serait une antenne de faible épaisseur. Il en résulte que si la couche support n'a pas l'épaisseur requise exactement, soit le fraisage n'atteint pas la surface de l'antenne et le contact électrique ne peut se faire, soit le fraisage mange l'antenne et le résultat est le même, il ne peut plus y avoir de connexion fiable.

Un procédé perfectionné est alors envisagé. Il résout le problème de l'échec des réalisations des connexions entre une puce et un circuit électrique présent dans une couche enterrée de la carte. Dans ce perfectionnement, les puits de connexion sont creusés avant assemblage des couches du support de la carte. Cet assemblage résulte par exemple d'un co-laminage. Comme les puits sont creusés à part, il n'y a pas de risque de perforation des plots de contact du circuit secondaire. De préférence la réalisation des puits est simultanée à la réalisation de la cavité dans la couche concernée, de sorte que le procédé n'implique pas de phase supplémentaire de fabrication.

A cet effet l'invention concerne donc un procédé de réalisation d'une carte à puce, comportant les étapes suivantes
- on forme une première couche isolante de constitution d'un corps de la carte,
- on réalise des puits dans cette première couche constituante,
- on plaque, contre cette première couche constituante, une face d'un circuit électrique secondaire
- on réalise par ailleurs une deuxième couche constituante plaquée contre l'autre face du circuit électrique secondaire,
- on remplit les puits de colle conductrice,
- on met en place un circuit électrique principal comportant des métallisations, pour être connecté à un lecteur de cartes à puce à contact, la colle conductrice dans les puits étant alors en contact direct avec deux points de connexion du circuit électrique secondaire et avec deux points de connexion du circuit électrique principal par le dessous des métallisations de ce circuit électrique principal.

La colle conductrice dans les puits entre en contact avec deux points de connexion du circuit électrique principal par l'intermédiaire de métallisations de ce circuit électrique principal et avec deux points de connexion de ce circuit électrique secondaire.

En suivant ces procédés, une carte à puce mixte est réalisée. Cette carte à puce a au moins deux couches plaquées l'une contre l'autre et un circuit électrique secondaire est présent entre ces deux couches. Dans une première couche, un circuit principal est réalisé sous la forme d'un micromodule. Le circuit principal comportant des métallisations joue un rôle d'interface avec un lecteur de cartes à puce. Des puits de connexion creusés dans la première couche, sont remplis d'une colle conductrice. Cette colle permet d'établir un lien électrique entre une métallisation du circuit principal et un point de connexion du circuit secondaire.

L'invention concerne donc une carte à puce comportant
- un circuit électrique principal,
- un circuit électrique secondaire présent dans une couche enterrée de la carte, ladite couche enterrée comportant des couches constituantes plaquées l'une contre l'autre avec le circuit électrique secondaire présent entre elles,
- un micromodule ayant une zone de renflement où est fixée la puce et des ailes de part et d'autre du renflement, l'une des couches constituantes comportant deux puits de connexion remplis de colle conductrice,
caractérisé en ce que cette colle conductrice dans les deux puits est en contact direct avec deux points de connexion du circuit électrique secondaire et avec deux points de connexion du circuit électrique principal par le dessous de métallisations dudit circuit électrique principal, ces métallisations assurant une connexion de la carte à puce à un lecteur de carte à puce à contact.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1 : une vue de profil d'une carte à puce selon l'invention;
- Figure 2a : une vue de dessus d'une carte à puce selon l'invention;
- Figure 2b **:** une vue de dessous d'un micromodule de carte à puce qui n'est pas selon l'invention.

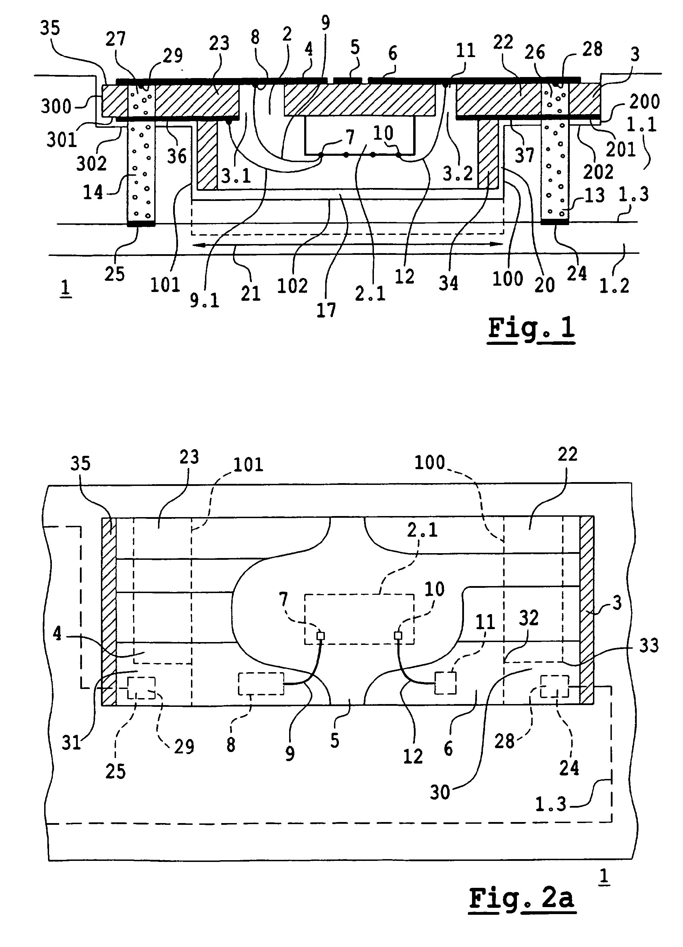

La figure 1 montre une vue de profil d'une carte à puce 1 conforme à l'invention. La carte à puce 1 comporte ici deux couches constituantes 1.1 1.2 entre lesquelles se loge un circuit électrique 1.3 secondaire.

La carte 1 porte un micromodule 2. Le micromodule 2 comporte une puce 2.1, et est ici portée par un film isolant 3. Ce film isolant 3 peut être en plastique ou en résine renforcée par des fibres. Des zones conductrices 4, 5, et 6 sont réalisées sur la face supérieure du film 3, par exemple grâce à des métallisations. Dans un exemple le film est un film entièrement métallisé, les métallisations 4 à 6 étant gravées pour les individualiser. La puce 2.1 est fixée contre la face inférieure du film isolant 3.

Pour permettre une connexion entre une zone conductrice 4 à 6 et la puce 2.1,on réalise des trous tels que 3.1 et 3.2 dans le film 3. Les trous 3.1 et 3.2 permettent ici d'établir respectivement une connexion entre un plot 7 de la puce 2.1 et un point de contact 8 de la métallisation 4 par l'intermédiaire d'un fil conducteur 9, et une connexion entre un plot 10 de la puce 2.1 et un point de connexion 11 de la métallisation 6 par l'intermédiaire d'un fil conducteur 12. Cette connexion est réalisée par une machine de wire bonding qui prépare les micromodules 2.

Le micromodule 2 est encastré dans un logement 20 de la carte 1. Selon les différents modes de réalisation, le logement 20 peut se situer dans la couche constituante 1.1 seule, ou dans la couche constituante 1.1 et dans la couche constituante 1.2. Le micromodule 2 présente dans un exemple préféré une zone 21 de renflement où est fixée la puce 2.1 et des ailes fines, ici 22 et 23 de part et d'autre du renflement 21. Le renflement 21 a deux côtés latéraux 100 et 101 et un fond 102. Le fond 102 repose contre un fond du logement 20, dans la couche constituante 1.1 ou la couche constituante 1.2, selon la profondeur désirée pour la puce. Une première aile 22 a un bord 200 et un fond 201. Une deuxième aile 23 a un bord 300 et un fond 301. Les fonds 201 et 301 des ailes 22 et 23 reposent sur des marches 202 et 302 réalisés dans la couche constituante 1.1.

La couche constituante 1.2 inférieure est surmontée par le circuit électrique secondaire 1.3. Dans un exemple préféré, le circuit 1.3 est une antenne. Cette antenne est par exemple formée par une spire plate unique. De préférence, dans le cas de spires, la spire 1.3 est obtenue par gravure d'une métallisation portée par la couche constituante 1.2. De ce fait, l'épaisseur de l'antenne peut être très faible. Le circuit électrique secondaire 1.3 comporte deux plots de connexion 24 et 25 disposés aux extrémité du circuit 1.3. Pour raccorder le circuit 1.3 au circuit principal contenu dans le micromodule 2, on connecte le dessous de la métallisation 4 et le plot 25 et le dessous de la métallisation 6 et le plot 24. Cette connexion est obtenue par un déversement de colle conductrice dans des puits de connexion 13 et 14 réalisés dans la couche 1.1. Les puits sont réalisés à cet effet dans les marches 202 et 302. Deux procédés sont possibles.

Dans un premier procédé, qui n'est pas le procédé préféré, les couches constituantes 1.1 et 1.2 sont assemblées de part et d'autre du circuit 1.3 (celui-ci pouvant résulter d'une gravure d'une métallisation générale de la face supérieure de la couche 1.2). Le micromodule est introduit dans une cavité (ou logement) 20 de la couche 1.1. Les puits 13 et 14 sont ensuite fraisés dans la couche constituante 1.1 et les ailes du micromodule. Le fraisage doit alors s'arrêter exactement dans l'épaisseur des plots 24 et 25. Dans ce cas, le creusement de la cavité 20 et des marches 202 et 302, dans la couche 1.1 ou dans les couches 1.1 et 1.2, peut être préalable ou postérieur à l'assemblage de ces couches.

Dans un deuxième procédé préféré, la couche 1.1 est préperforée par les puits 13 et 14 avant sa mise en place au-dessus de la couche 1.2, et donc des plots 24 et 25 du circuit 1.3 interposé. Ce circuit 1.3 peut ici aussi être gravé ou résulter de la mise en place d'une feuille découpée selon un dessin de spire attendu. Dans ce cas, de préférence, la cavité 20 aura été préparée dans la couche 1.1 avant mise en place de cette couche 1.1 sur les couche 1.2 et 1.3. Ce sera le cas en particulier si la cavité 20 doit s'étendre dans les deux couches 1.1 et 1.2, car alors elle peut être obtenue par matriçage de la couche 1.1. Ce matriçage de la couche 1.1 se produira alors de préférence après un estampage de la couche 1.1 au cours duquel seront réalisées les marches 202 et 302. Le matriçage de la cavité 20 sera réalisé en même temps que le matriçage des puits 13 et 14 de sorte que ces derniers ne nécessiteront aucune étape supplémentaire. Seule la matrice sera de forme différente.

Après ces opérations les différentes couches constitutives de la carte 1 sont assemblées. L'assemblage est ensuite laminé.

Le film isolant 3 du micromodule 2 est par ailleurs préalablement ajouré par des trous 26 et 27. Les trous 26 et 27 sont situés à l'endroit, en regard des puits 13 et 14 respectivement, où le micromodule est présenté dans la cavité 20. A l'endroit de ces trous 26 et 27, les métallisations 4 et 6 présentent respectivement des points de connexion 28 et 29. Ces points de connexion 28 et 29 sont utilisés pour permettre les liaisons électriques avec les plots 24 et 25 respectivement en déversant de la colle conductrice dans les puits 13 et 14.

Les puits de connexion 13 et 14 débouchent respectivement à l'endroit des fonds 201 et 301 des ailes. Pour remplir les puits de colle conductrice, on peut utiliser une colle isolante (très fluide) chargée avec des particules conductrices. La mise en place de cette colle conductrice est réalisée avant mise en place du micromodule 2. On règle la quantité de colle déversée de telle façon que la colle déversée forme une goutte en surépaisseur au-dessus des marches 202 et 302. Ensuite on met en place le micromodule 2 c'est-à-dire on met en place le circuit électrique principal comportant des métallisations 4 à 6 pour être connecté à un lecteur de cartes à puce à contact dans la cavité 20 de la couche 1.1. La cavité est ici constituée sur les faces 100, 101, 102, 200, 202, 300, et 302. Ainsi les points de connexion du circuit 1.3 pourront être relié aux métallisations 4 et 6 du circuit principal et à travers ces métallisations aux plots 7 et 10 respectivement.

Les trous 13 et 14 ont un diamètre supérieur à 1 mm. Un tel diamètre permet d'injecter la colle conductrice au moyen d'une seringue contenant la dose nécessaire pour remplir un puits de connexion avec un dôme pour remonter dans les trous 26 et 27. En particulier, il faut qu'il y ait assez de colle pour que celle-ci vienne au contact des points de connexion 28 et 29. Il ne faut pas qu'il y en ait de trop, pour que par excès elle ne vienne pas, le long des bords 200 et 300, remonter contre les pistes métallisées situées à coté des pistes 4 et 6. La dose est définie de telle sorte que la réalisation de la connexion soit possible. La colle doit avoir une viscosité qui permet une adhésion correcte aux parois du puits de connexion. Le bord supérieur de la colle, obtenu après remplissage du puits de connexion, doit se surélever et non s'affaisser.

La figure 2a montre une vue de dessus de la carte à puce 1. Montré en tirets, le circuit 1.3 est logé dans le corps de la carte et se termine par les plots 24 et 25. Ces plots sont situés à l'aplomb des points de contacts 28 et 29 situés sous les métallisations 6 et 4 respectivement. Ces points de contact 28 et 29 sont reliés par les métallisations 4 et 6 aux points de contact 11 et 8 respectivement, lesquels sont reliés par les fils 12 et 9 aux plots 10 et 7 de la puce 2.1. Selon une première forme de réalisation, les ailes 22 et 23 s'étendent parallèlement à un bord 100 et 101 de la cavité 20. Selon une variante, les ailes 22 et 23 sont confinées à des onglets 30 et 31. Ces onglets résultent d'une réalisation des bords 100 et 101 avec des décrochements tels que 32 et 33 du contour des murs 34 (figure 1) du micromodule 2. Des décrochements correspondant doivent être réalisés dans l'emporte pièce qui sert pour le matriçage ou l'estampage.

Dans ces cas les puits de connexion ont un diamètre supérieur à 1 mm mais inférieur à 2 mm car ils doivent être contenus dans la surface de chaque marche. Et chaque marche a une largeur, et ou une longueur à l'endroit des décrochements 32 et 33, de l'ordre de 3 mm. La colle doit être assez fluide pour descendre au fond des puits et pour remonter par capillarité dans les trous 26 et 27.

Les métallisations 4 à 6 peuvent occuper toute la surface de la vignette, ou être légèrement en retrait 35 pour éviter les courts-circuits par débordement de colle conductrice dans les interstices entre le micromodule 2 et les chants correspondant aux bords 200 et 300.

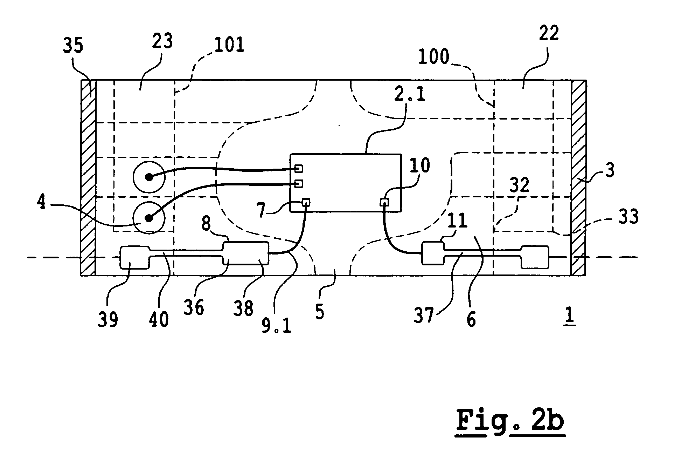

Dans une variante de réalisation, figure 2b, qui n'est pas selon l'invention on cherche à éviter que des potentiels électriques subis par les métallisations telles que 4 à 6 ne viennent perturber des signaux échangés entre la puce 2.1 et le circuit 1.3. Dans ce but, les connexions entre cette puce 2.1 et ce circuit 1.3 sont réalisées par l'intermédiaire de métallisations telles que 36 et 37, figures 1 et 2b. Les métallisations 36 et 37 sont réalisées sur le dos du film isolant 3, sur un coté de ce film 3 opposé à celui où sont réalisées les métallisations apparentes 4 à 6. Les métallisations 36 et 37 sont réalisées bien entendu en dehors des endroits où des trous tels que 3.1 et 3.2 permettent à la puce 2.1 d'être connectée à ces métallisations 4 à 6. Dans un exemple, le circuit électrique secondaire 1.3 s'étend dans le corps de la carte, autour du circuit électrique principal.

Les métallisations 36 et 37 comportent deux plages principales. Une première plage telle que 38 permet la liaison électrique de la métallisation 36 à un plot tel que 7 de la puce 2.1 par l'intermédiaire d'une liaison 9.1 (en lieu et place d'une liaison 9). Une deuxième plage 39 reliée par une connexion 40 à la plage 38 est située en regard de la position attendue du puits 14. En choisissant cette solution, d'une part il n'y a plus à craindre de décharges électrostatiques appliquées par un opérateur qui placerait un doigt sur la métallisation apparente 4, d'autre part il n'est plus nécessaire de réaliser un trou 27 pour connecter la plage 4 au plot 7, et enfin, il n'est plus nécessaire de caractériser la colle pour qu'elle ait à remonter dans ce trou 27. En effet, il suffit au dessus du puits 14 de laisser une légère bosse de colle conductrice pour que celle-ci vienne au contact de la plage métallisée 39. Dans la variante préférée, la puce est également connectée aux métallisation 36 et 37 en même temps que d'autres de ses plots sont connectés aux métallisations 4 à 6.

Les métallisations 36 et 37 passent sous les murs tels que 34. Ceci peut être réalisé simplement en constituant ces murs, ou des anneaux équivalents, en déposant préalablement un filet de matière isolante autour de la puce avant de remplir l'espace circonscrit par ce filet par cette même matière isolante. En agissant ainsi, il suffit d'utiliser un film 3 métallisé double face et d'y graver les métallisations voulues, de chaque coté, en même temps.

## Revendications

1. - Procédé de réalisation d'une carte à puce (1), comportant les étapes suivantes :
- on forme une première couche isolante (1.2) de constitution d'un corps de la carte,
- on plaque contre cette première couche constituante (1.2) une première face d'un circuit électrique secondaire (1.3),
- on réalise par ailleurs une deuxième couche constituante (1.1) plaquée contre une deuxième face du circuit électrique secondaire (1.3),
- on introduit, dans une cavité (20) de cette deuxième couche constituante, un micromodule (2) ayant une puce (2.1), une zone de renflement où est fixée la puce et des ailes (22, 23) de part et d'autre du renflement,
- on fraise des puits (13,14) dans les ailes du micromodule et dans la deuxième couche constituante jusqu'à la deuxième face du circuit secondaire,
- on remplit les puits d'une colle conductrice,
- on met en place un circuit électrique principal comportant des métallisations (4-6) pour être connecté à un lecteur de cartes à puce à contact, la colle conductrice dans les puits étant alors en contact direct avec deux points de connexion (24, 25) du circuit électrique secondaire et avec deux points de connexion (28, 29) du circuit électrique principal par le dessous des métallisations de ce circuit électrique principal .

2. - Procédé de réalisation d'une carte à puce (1), comportant les étapes suivantes
- on forme une première couche isolante (1.1) de constitution d'un corps de la carte,
- on réalise des puits (13,14) dans cette première couche constituante,
- on plaque, contre cette première couche constituante, une face d'un circuit électrique secondaire (1.3),
- on réalise par ailleurs une deuxième couche constituante (1.2) plaquée contre l'autre face du circuit électrique secondaire,
- on remplit les puits de colle conductrice,
- on met en place un circuit électrique principal comportant des métallisations (4-6) pour être connecté à un lecteur de cartes à puce à contact, la colle conductrice dans les puits étant alors en contact direct avec deux points de connexion (24, 25) du circuit électrique secondaire et avec deux points de connexion (28, 29) du circuit électrique principal par le dessous des métallisations de ce circuit électrique principal.

3. - Carte à puce (1) **comportant :**
- un circuit électrique principal,
- un circuit électrique secondaire (1.3) présent dans une couche enterrée de la carte, ladite couche enterrée comportant des couches constituantes (1.1, 1.2) plaquées l'une contre l'autre avec le circuit électrique secondaire présent entre elles,
- un micromodule (2) ayant une zone de renflement où est fixée la puce (2.1) et des ailes (22, 23) de part et d'autre du renflement, l'une des couches constituantes comportant deux puits de connexion (13,14) remplis de colle conductrice,
**caractérisé en ce que** cette colle conductrice dans les deux puits est en contact direct avec deux points de connexion (24, 25) du circuit électrique secondaire (1.3) et avec deux points de connexion (28, 29) circuit électrique principal par le dessous de métallisations (4-6) dudit circuit électrique principal, ces métallisations assurant une connexion de la carte à puce à un lecteur de carte à puce à contact.

4. - Carte selon la revendication 3, **caractérisée en ce que** les puits sont réalisés dans une couche constituante avant un assemblage des couches composant la carte à puce.

5. - Carte selon la revendication 4, **caractérisée en ce que** la couche constituante munie des puits de connexion comporte des marches (202,203) pour recevoir les ailes du micromodule en affleurement, les puits débouchant dans ces marches.

6. - Carte selon l'une des revendications 3 à 5, **caractérisée en ce que** le micromodule est muni d'un film isolant (3) ajouré, la puce étant fixée à ce film isolant ajouré.

7. - Carte selon l'une des revendications 3 à 6, **caractérisée en ce que** le micromodule comporte une substance isolante (17) pour remplir un espace vide situé à l'endroit de la zone où est placée la puce.

8. - Carte selon l'une des revendications 3 à 7, **caractérisée en ce que** la colle conductrice comporte une colle isolante chargée avec des particules conductrices.

9. - Carte selon l'une des revendications 3 à 8, **caractérisée en ce que** les dimensions d'un puits sont suffisantes pour permettre l'injection d'une colle conductrice, et en particulier présentent un diamètre supérieur à 1 mm.

10. - Carte selon l'une des revendications 3 à 9, **caractérisé en ce que** le circuit électrique secondaire s'étend dans le corps de la carte, autour du circuit électrique principal.

## Claims

1. - Method for the making a chip card (1) comprising the following steps:
- forming a first insulator layer (1.2) for constituting a body of the card,
- placing a first face of a secondary electrical circuit (1.3) flat against this first constituent layer (1.2),
- furthermore making a second constituent layer (1.1) placed flat against a second face of the secondary electrical circuit (1.3),
- introducing, in a cavity (20) of this second constituent layer, a micromodule (2) having a chip (2.1), a bulge zone where the chip is fixed and wings (22, 23) on either side of the bulge,
- machining wells (13, 14) in the wings of the micromodule and in the second constituent layer up to the second face of the secondary circuit,
- filling the wells with a conductive bonder,
- positioning a main electrical circuit comprising metallizations (4-6) to be connected to a contact chip-card reader, the conductive bonder in the wells being then in direct contact with two connection points (24, 25) of the secondary electrical circuit and with two connection points (28, 29) of the main electrical circuit by the under side of the metallizations of this main electrical circuit.

2. - Method for making a chip card (1), comprising the following steps:
- forming a first insulator layer (1.1) for constituting a body of the card,
- making wells (13, 14) in this first constituent layer,
- placing a face of a secondary electrical circuit (1.3) flat against this first constituent layer,
- furthermore making a second constituent layer (1.2) placed flat against the other face of the secondary electrical circuit (1.3),
- filling the wells with conductive bonder,
- positioning a main electrical circuit comprising metallizations (4-6) to be connected to a contact chip-card reader, the conductive bonder in the wells being then in direct contact with two connection points (24, 25) of the secondary electrical circuit and with two connection points (28, 29) of the main electrical circuit by the under side of the metallizations of this main electrical circuit

3. - chip card (1) comprising:
- a main electrical circuit.
- a secondary electrical circuit (1.3) present in a buried layer of the card, said buried layer comprising constituent layers (1.1, 1.2) placed flat against each other with the secondary electrical circuit present between them,
- a micromodule (2) having a bulging zone to which the chip (2.1) is fixed and wings (22,23) on either side of the bulging zone, one of the constituent layers comprising two connection wells (13,14) filled with conductive bonder,
**characterised in that** this conductive bonder in the two wells is in direct contact with two connection points (24, 25) of the secondary electrical circuit (1.3) and with two connection points (28, 29) of the main electrical circuit by the under side of the metallizations (4-6) of said main electrical circuit, these metallizations providing for a connection of the chip card to a contact card reader.

4. - Card according to claim 3, **characterised in that** the wells are made in a constituent layer before an assembling of the layers comprising the chip card.

5. - Card according to claim 4 **characterised in that** the constituent layers provided with connection wells comprises steps (202, 203) to receive the wings of the micromodule in a flush position, the wells opening out on to the steps

6. - Card according to one of the claims 3 to 5, **characterised in that** the micromodule is provided with a slotted insulating film (3), the chip being fixed to this slotted insulating filling.

7. - Card according to one of the claims 3 to 6, **characterised in that** the micromodule comprises an insulator substance (17) to fill a vacant space situated at the position of the zone in which the chip is placed.

8. - Card according to one of the claims 3 to 7, **characterised in that** the conductive bonder comprises an insulator bonder charged with conductive particles.

9. - Card according to one of the claims 3 to 8, **characterised in that** the dimensions of a well are sufficient to enable the injection of a conductive bonder, and especially have a diameter greater than 1 mm.

10. - Card according to one of the claims 3 to 9, **characterised in that** the secondary electrical circuit extends in the body of the card, around the main electrical circuit.

## Patentansprüche

1. - Verfahren zur Herstellung einer Chipkarte (1) mit folgenden Schritten:
- man bildet eine erste isolierende Aufbauschicht (1.2) eines Kartenkörpers,
- man drückt gegen diese erste Aufbauschicht (1.2) eine erste Seite eines Sekundärstromkreislaufs (1.3),
- man bildet darüber hinaus eine zweite Aufbauschicht (1.1), die gegen eine zweite Seite des Sekundärstromkreislaufs (1.3) gedrückt wird,
- man führt in eine Vertiefung (20) dieser zweiten Aufbauschicht ein Mikromodul (2) mit einem Chip (2.1), einem Verdickungsbereich, in dem der Chip befestigt ist, sowie Flügel (22, 23) beiderseits der Verdickung ein,
- man fräst Schächte (13, 14) in die Flügel des Mikromoduls und in die zweite Aufbauschicht bis zur zweiten Seite des Sekundärstromkreislaufs,
- man befüllt die Schächte mit einem leitenden Kleber,
- man setzt einen Hauptstromkreis mit leitenden Verbindungen (4-6) zur Verbindung mit einem Berührungs-Chiplesegerät ein, wobei der leitende Kleber in den Schächten über die Unterseite der leitenden Verbindungen des Hauptstromkreises in direktem Kontakt mit den beiden Verbindungspunkten (24, 25) des Sekundärstromkreislaufs und den beiden Verbindungspunkten (28, 29) des Hauptstromkreises steht.

2. - Verfahren zur Herstellung einer Chipkarte (1) mit folgenden Schritten
- man bildet eine erste isolierende Aufbauschicht (1.1) eines Kartenkörpers,
- man bildet Schächte (13, 14) in dieser ersten Aufbauschicht,
- man drückt gegen diese erste Aufbauschicht (1.1) eine Seite eines Sekundärstromkreislaufs (1.3),
- man bildet darüber hinaus eine zweite Aufbauschicht (1.2), die gegen die andere Seite des Sekundärstromkreislaufs gedrückt wird,
- man befüllt die Schächte mit einem leitenden Kleber,
- man setzt einen Hauptstromkreis mit leitenden Verbindungen (4-6) zur Verbindung mit einem Berührungs-Chiplesegerät ein, wobei der leitende Kleber in den Schächten über die Unterseite der leitenden Verbindungen des Hauptstromkreises in direktem Kontakt mit den beiden Verbindungspunkten (24, 25) des Sekundärstromkreislaufs und den beiden Verbindungspunkten (28, 29) des Hauptstromkreises steht.

3. - Chipkarte (1) mit:
- einem Hauptstromkreis
- einem Sekundärstromkreis (1.3) in einer verdeckten Schicht der Karte, wobei die besagte verdeckte Schicht Aufbauschichten (1.1, 1.2) enthält, die gegeneinander gedrückt sind, und der Sekundärstromkreis dazwischen liegt,
- einem Mikromodul (2) mit einem Verdickungsbereich, in dem der Chip (2.1) befestigt ist, und Flügeln (22, 23) beiderseits der Verdickung, wobei eine der Aufbauschichten zwei Verbindungsschächte (13, 14) enthält, die mit leitendem Kleber gefüllt sind,
**dadurch gekennzeichnet, dass** dieser leitende Kleber in den beiden Schächten über die Unterseite der leitenden Verbindungen (4-6) des Hauptstromkreises in direktem Kontakt mit den beiden Verbindungspunkten (24, 25) des Sekundärstromkreises (1.3) und den beiden Verbindungspunkten (28, 29) des Hauptstromkreises steht, wobei diese leitenden Verbindungen eine Verbindung zwischen der Chipkarte und einem Berührungs-Kartenlesegerät herstellen.

4. - Karte nach Anspruch 3, die **dadurch gekennzeichnet ist, dass** die Schächte vor der Zusammenstellung der die Chipkarte bildenden Schichten in einer Aufbauschicht eingearbeitet werden.

5. - Karte nach Anspruch 4, die **dadurch gekennzeichnet ist, dass** die Aufbauschicht mit den Verbindungsschächten Stufen (202, 203) enthält, um die Flügel des Mikromoduls in Ausnehmungen aufzunehmen, wobei die Schächte in diese Stufen münden.

6. - Karte nach einem der Ansprüche 3 bis 5, die **dadurch gekennzeichnet ist, dass** das Mikromodul mit einer Isolierschicht (3) mit Öffnungen überzogen ist, wobei der Chip auf dieser Isolierschicht mit Öffnungen befestigt ist.

7. - Karte nach einem der Ansprüche 3 bis 6, die **dadurch gekennzeichnet ist, dass** das Mikromodul eine Isoliersubstanz (17) enthält, um einen Hohlraum auszufüllen, der sich in dem Bereich befindet, in dem der Chip angebracht ist.

8. - Karte nach einem der Ansprüche 3 bis 7, die **dadurch gekennzeichnet ist, dass** der leitende Kleber einen isolierenden Kleber enthält, der mit leitenden Teilchen versetzt ist.

9. - Karte nach einem der Ansprüche 3 bis 8, die **dadurch gekennzeichnet ist, dass** die Abmessungen eines Schachtes ausreichend sind, um das Einspritzen eines leitenden Klebers zu ermöglichen, und im Besonderen einen Durchmesser von über 1 mm aufweisen.

10. - Karte nach einem der Ansprüche 3 bis 9, die **dadurch gekennzeichnet ist, dass** sich der Sekundärstromkreis über den Kartenkörper rund um den Hauptstromkreis erstreckt.
